Europäisches Patentamt

(19) European Patent Office

Office européen des brevets

(11) Numéro de publication: **0 086 161**
**B1**

(12) FASCICULE DE BREVET EUROPEEN

(45) Date de publication du fascicule du brevet:
14.05.86

(51) Int. Cl.⁴: **G 01 R 31/02**, G 01 R 31/28

(21) Numéro de dépôt: **83400270.1**

(22) Date de dépôt: **08.02.83**

(54) Dispositif de contrôle de l'isolement des circuits imprimés.

(30) Priorité: **10.02.82 FR 8202287**

(43) Date de publication de la demande:
**17.08.83 Bulletin 83/33**

(45) Mention de la délivrance du brevet:
**14.05.86 Bulletin 86/20**

(84) Etats contractants désignés:
**BE CH DE GB IT LI LU NL SE**

(56) Documents cités:
**IBM TECHNICAL DISCLOSURE BULLETIN, vol. 22, no. 7, décembre 1979, pages 2704-2705, New York, USA, L.M. YOBNIW: "Orthogonal shorts detector"**
**IBM TECHNICAL DISCLOSURE BULLETIN, vol. 12, no. 5, octobre 1969, pages 655-656, New York, USA, P.M. DEGROAT et al.: "Finding shorts in printed circuit boards"**

(73) Titulaire: **CROUZET, 128, Avenue de la République, F-75011 Paris (FR)**

(72) Inventeur: **Saroul, Jacques, 69, Chemin de la Prat, F-26000 Valence (Drôme) (FR)**

(74) Mandataire: **Bloch, Robert et al, 39 avenue de Friedland, F-75008 Paris (FR)**

## Description

La présente invention concerne un dispositif de contrôle qualitatif de l'isolement galvanique entre des éléments conducteurs d'un circuit imprimé complexe, comprenant des moyens explorateurs de pastilles métalliques accessibles sur une des faces du circuit imprimé, et des moyens indicateurs de l'isolement galvanique.

Il s'agit en fait du contrôle qualitatif de l'isolement électrique des circuits imprimés réalisés notamment en couches multiples superposées sur des supports isolants à structure laminaire au moyen de technologies conventionnelles ou hybrides.

Il est bien connu des milieux industriels spécialisés dans l'élaboration et la production des circuits imprimés complexes que l'on a intérêt à déceler leurs défauts qualitatifs le plus tôt possible dans le processus de fabrication afin d'éviter des rebuts d'autant plus coûteux que les circuits imprimés comportent de valeur technologique ajoutée et que leur défectuosité, particulièrement en matière d'isolement, s'avère le plus souvent irrémédiable.

Dans ce souci d'ordre essentiellement économique, l'état actuel de la technique pratiquée pour effectuer le contrôle qualitatif de l'isolement fonctionnel des circuits imprimés multicouches consiste à utiliser un système de palpeurs à pointes élastiques conductrices simultanément appliquées sur chacune des pastilles conductrices présentes sur les faces accessibles du circuit imprimé à contrôler. Chacun de ces palpeurs est connecté à un indicateur d'isolement par l'intermédiaire d'une unité logique d'interconnexion sélective – ou combinatoire – dont le programme d'exploration est spécifiquement établi en fonction des caractéristiques typiques du circuit imprimé à contrôler.

L'inconvénient majeur de cette technique réside dans le fait qu'elle nécessite la réalisation d'un dispositif palpeur à pointes multiples dont la configuration doit être adaptée à chaque modèle particulier de circuit imprimé.

En effet, cette réalisation toujours fort onéreuse et de fiabilité souvent problématique pour s'adapter à des circuits imprimés de dimensions «normales», devient pratiquement irréalisable de façon économiquement acceptable et techniquement fiable dans la plupart des cas d'applications industrielles – notamment dans le domaine des équipements aéronautiques et spatiaux – où pour des raisons de compacité et de densité de circuits on est conduit à élaborer des circuits imprimés spéciaux dont les caractéristiques structurelles ne correspondent à aucune norme dimensionnelle qui permettrait l'utilisation d'un même et unique dispositif palpeur adaptable à plusieurs modèles différents de circuits imprimés.

Par ailleurs, on connaît un dispositif du type mentionné ci-dessus, par le document IBM Technical Disclosure Bulletin volume 22, numéro 7, décembre 1979 pages 2704–2705, New-York, USA L.M. ZOBNIW: «Orthogonal shorts detector».

Néanmoins, le dispositif de ce document comportant comme moyens explorateurs une sonde ponctuelle et une sonde transversale ayant accès, dans une même position, à plusieurs sorties d'un même arbre, il est impératif, avec ce dispositif de déplacer la sonde transversale dans deux directions différentes, ce qui peut ne pas être préjudiciable en cas de réparation de circuits imprimés, mais ce qui est une contrainte au niveau du contrôle de fabrication qui met en jeu de grandes quantités.

La présente invention vise donc, à partir d'un dispositif du type mentionné ci-dessus, à proposer un dispositif permettant une économie de temps et de main-d'œuvre pour le contrôle de la fabrication des circuits imprimés.

A cet effet, la présente invention concerne un dispositif du type mentionné ci-dessus, caractérisé par le fait qu'il comprend des moyens palpeurs spécifiques comportant une pluralité d'éléments de contact individuel localisés sur un écran isolant pour effectuer, par superposition, la sélection d'une catégorie prédéfinie de pastilles parmi l'ensemble des pastilles métalliques accessibles sur ladite face du circuit imprimé, lesdits moyens explorateurs étant agencés pour explorer les éléments de contact individuel des moyens palpeurs spécifiques et comportant des éléments de contact collectif mutuellement isolés et fixés entre eux, pour permettre d'opérer dynamiquement la détection d'un éventuel défaut d'isolement affectant mutuellement les différents «arbres» conducteurs du circuit imprimé, et les moyens indicateurs traduisant la mesure de l'isolement galvanique existant entre les éléments de contact collectif des moyens explorateurs.

Le dispositif de l'invention permet, dans des conditions économiques et fiables, un contrôle qualitatif de l'isolement des circuits imprimés multicouches de divers types et configurations, y compris ceux les plus compacts et les plus complexes obtenus en technologie hybride.

L'invention telle qu'elle est essentiellement définie ci-dessus sera mieux comprise grâce à l'explication qui suit d'un exemple simple de réalisation donnée en référence au dessin annexé qui représente:

– Fig. 1: un circuit imprimé-type, à contrôler, comportant un certain nombre d'«arbres» conducteurs implantés sur chaque face.

– Fig. 2: un circuit palpeur spécifique ne comportant qu'un seul plot conducteur par «arbre» du circuit-type de la figure 1.

– Fig. 3: un circuit explorateur comportant deux plages conductrices superficielles coplanaires galvaniquement isolées l'une de l'autre par une discontinuité transversale rectiligne.

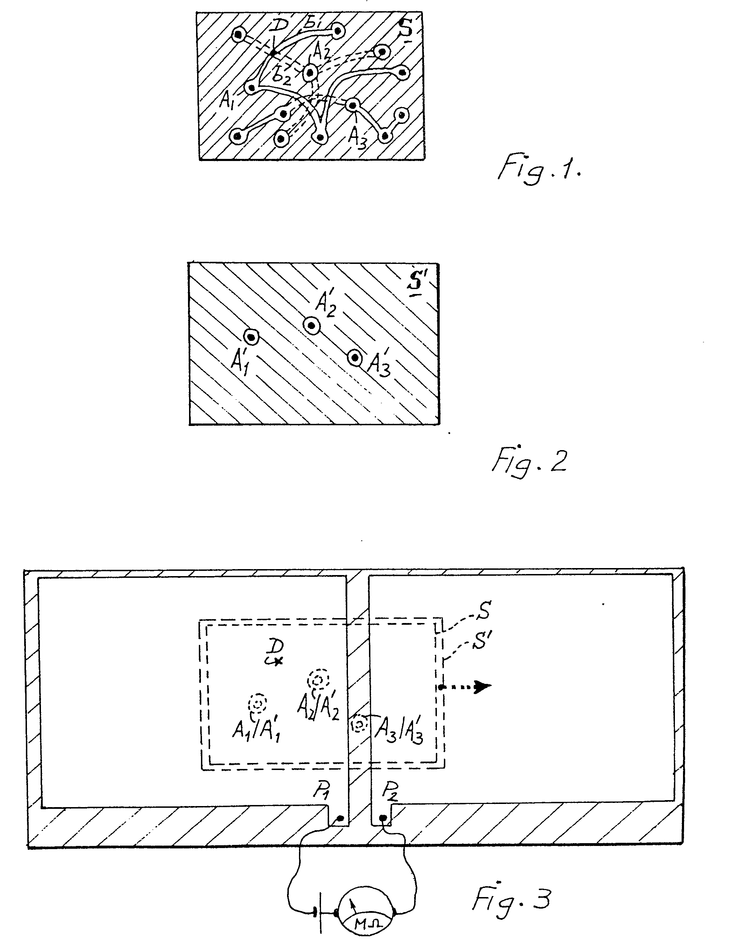

Un circuit imprimé de série-type – tel que celui d'un modèle très simplifié, pour la clarté de l'exposé, représenté fig. 1 est constitué de façon classique d'un support isolant laminaire S plus ou moins rigide et plan dont l'une et l'autre des faces sont constellées d'une pluralité agencée de pastilles métalliques adhérentes au support dont la plupart sont reliées par des pistes conductrices de manière à former selon des nappes superposées un réseau élaboré et complexe d'interconnexions électriques.

Les divers ramifications de ce réseau d'interconnexions sont généralement organisées selon des ensembles conducteurs distincts qui doivent être galvaniquement isolés les uns des autres. Ces ensembles isolés constituent alors des «arbres» dont les «branches» respectives peuvent se continuer d'une face à l'autre du support isolant, par les trous à paroi métallisée ménagés au centre de chacune des pastilles et destinés par ailleurs à permettre la connexion par soudure des différents composants d'un circuit électronique monté en carte.

Le problème du contrôle qualitatif d'un tel circuit imprimé consiste essentiellement à mettre en évidence de manière certaine et rapide l'existence d'un défaut d'isolement entre deux «arbres».

Un tel défaut, pratiquement indiscernable par un examen de contrôle visuel, est supposé exister par une faille du support isolant au point D de croisement entre deux branches $b_1$ et $b_2$ des deux «arbres» $A_1$ et $A_2$.

Afin d'opérer ce contrôle on a réalisé un circuit palpeur spécifique 5' dont les caractéristiques ont été définies au stade de la conception du circuit type.

Ce circuit palpeur spécifique, ainsi que l'illustre la fig. 2, est constitué d'un support isolant souple et mince sur lequel on a laissé subsister qu'une seule pastille conductrice par arbre du circuit-type à contrôler.

Chacune des pastilles du circuit palpeur qui est située en rigoureuse coïncidence avec l'une quelconque des pastilles de chacun des «arbres» du circuit-type est obtenue par la métallisation de trous ménagés dans le support souple de manière à disposer de part et d'autre d'un écran isolant une pluralité de minuscules plots conducteurs.

Ces plots se présentent, de préférence, avec une structure analogue à celle d'un rivet dont l'une des têtes est plate et de diamètre rigoureusement défini alors que l'autre tête est bombée de manière à faire légèrement saillie par rapport à la face correspondante de l'écran isolant.

Selon une technologie préférée, l'écran isolant est réalisé avec du film de polyimide – par exemple tel que du KAPTON – dont la métallisation des trous est obtenue grâce à un procédé photochimique de dépôt localisé de cuivre.

Ainsi réalisé, le circuit palpeur spécifique est destiné à permettre d'établir, grâce à l'interposition de l'écran souple isolant, un contact électrique équipotentiel sélectif et localisé avec précision entre une pastille conductrice déterminée de chaque «arbre» du circuit-type à contrôler et l'une ou l'autre des plages conductrices coplanaires $P_1$, $P_2$ du circuit explorateur qui est également réalisé sur un support isolant souple du genre polyimide métallisé sur une seule face et fixé par la face opposée à un plan d'appui compressible du genre mousse de polyuréthane.

La face métallisée du circuit explorateur (fig. 3) réalisée, par exemple, grâce à un dépôt de cuivre, de métal et d'or pour être rendue lisse et peu sujette à l'abrasion et à la corrosion est constituée de deux plages rectangulaires conductrices dont le plus petit côté doit être supérieur à la plusgrande dimension du circuit-type à contrôler.

Ces deux plages conductrices sont galvaniquement isolées l'une de l'autre par un espace de séparation transversal rectiligne ou sinueux et de largeur constante en contact et en travers duquel on opère le défilement continu (par un mouvement de glissement relatif exercé avec une pression élastique convenable) de l'ensemble maintenu solidaire constitué par l'exacte superposition du circuit imprimé-type à contrôler et du circuit palpeur souple qui lui correspond spécifiquement.

Afin de permettre le fonctionnement du dispositif précédemment décrit, c'est-à-dire, essentiellement, de permettre de déceler – et éventuellement de localiser – l'existence de défauts d'isolement entre les différents «arbres» conducteurs des circuits imprimés, il est impératif que d'une part, le circuit palpeur spécifique, tel que défini plus haut, ne comporte qu'un seul plot de contact équipotentiel pour chacun des «arbres» du circuit imprimé-type à contrôler et que, d'autre part, le diamètre des pastilles conductrices constituant, sur une même face, les têtes plates des plots dudit circuit palpeur soit un peu inférieur à la largeur de l'espace isolant séparant deux plages conductrices contiguës dudit circuit explorateur. Le processus de contrôle est alors le suivant:

1. Le circuit palpeur spécifique est superposé correctement sur le circuit imprimé-type à contrôler qui lui correspond de manière à faire coïncider leurs pastilles conductrices respectives.

2. Le circuit explorateur est alors appliqué contre l'ensemble précédent de manière à ce que les plages conductrices soient mises en contact permanent et intime avec la totalité des plots de contacts accessibles sur la face extérieure dudit circuit palpeur spécifique.

3. La mesure d'isolement entre deux «arbres» est effectuée de manière classique grâce par exemple à un mégohmètre branché entre les plages isolées du circuit explorateur sur chacune desquelles un des plots palpeurs correspondant individuellement à un «arbre» est respectivement en contact.

4. On imprime un mouvement continu de translation longitudinale par glissement relatif de l'ensemble solidairement superposé (circuit palpeur spécifique – circuit imprimé à contrôler) sur le circuit explorateur de manière à ce que les rangées de pastilles de contact du circuit palpeur défilent dans l'espace isolant de séparation des plages conductrices du circuit explorateur.

Un défaut d'isolement affectant deux «arbres» du circuit imprimé est immédiatement et automatiquement décelé et révélé par l'appareil de mesure indicateur d'isolement dès lors que les deux pastilles de contact appartenant respectivement à chacun des deux «arbres» mutuellement défectueux se trouvent situées de part et d'autre de l'espace isolant séparant les plages conductrices du circuit explorateur.

5. Afin d'obtenir, si nécessaire, la localisation précise du défaut, on répète l'opération précédente de translation glissante dans la direction transversale.

**Revendications**

1. Dispositif de contrôle qualitatif de l'isolement galvanique entre des éléments conducteurs d'un circuit imprimé complexe, comprenant des moyens explorateurs de pastilles métalliques accessibles sur une des faces du circuit imprimé, et des moyens indicateurs de l'isolement galvanique, caractérisé par le fait qu'il comprend des moyens palpeurs spécifiques (S') comportant une pluralité d'éléments de contact individuel ($A'_1$, $A'_2$, $A'_3$) localisés sur un écran isolant pour effectuer, par superposition, la sélection d'une catégorie prédéfinie de pastilles ($A_1$, $A_2$, $A_3$) parmi l'ensemble des pastilles métalliques accessibles sur ladite face du circuit imprimé (S), lesdits moyens explorateurs étant agencés pour explorer les éléments de contact individuel ($A'_1$, $A'_2$, $A'_3$) des moyens palpeurs spécifiques (S') et comportant des éléments de contact collectif ($P_1$, $P_2$) mutuellement isolés et fixés entre eux, pour permettre d'opérer dynamiquement la détection d'un éventuel défaut d'isolement affectant mutuellement les différents «arbres» conducteurs du circuit imprimé (S); et les moyens indicateurs ($M\Omega$) traduisant la mesure de l'isolement galvanique existant entre les éléments de contact collectif ($P_1$, $P_2$) des moyens explorateurs.

2. Dispositif selon la revendication 1, caractérisé par le fait que les éléments de contact individuel des moyens palpeurs spécifiques sont des plots conducteurs à double face ($A'_1$, $A'_2$, $A'_3$) obtenus par métallisation simultanée d'une pluralité de trous ménagés dans l'écran isolant (S').

3. Dispositif selon l'une des revendications 1 et 2, caractérisé par le fait que l'écran isolant (S') est un film de matière plastique souple.

4. Dispositif selon l'une des revendications 1 à 3, caractérisé par le fait que la localisation et le nombre des éléments de contact individuel des moyens palpeurs spécifiques (S') sont distribués sur l'écran isolant (S') de manière à disposer d'un seul plot conducteur par «arbre» du circuit imprimé (S).

5. Dispositif selon l'une des revendications 1 à 4, caractérisé par le fait que les éléments de contact collectif des moyens explorateurs sont des plages conductrices contiguës ($P_1$, $P_2$) obtenues par métallisation superficielle d'un support isolant déformable.

6. Dispositif selon la revendication 5, caractérisé par le fait que le support isolant déformable des moyens explorateurs est un film de matière plastique souple appliqué sur la face d'un corps d'appui compressible.

7. Dispositif selon l'une des revendications 5 et 6, caractérisé par le fait que les plages conductrices contiguës ($P_1$, $P_2$) des moyens explorateurs

sont coplanaires et mutuellement isolées par un espace de largeur constante et légèrement supérieure au diamètre des éléments de contact individuel ($A'_1$, $A'_2$, $A'_3$) apparaissant sur la face extérieure de l'écran isolant (S') des moyens palpeurs spécifiques lorsqu'il est solidairement superposé à la face d'épreuve du circuit imprimé (S).

8. Dispositif selon l'une des revendications 6 et 7, caractérisé par le fait que le matériau du film souple des moyens explorateurs est du polyimide et celui du corps compressible du polyuréthane.

9. Dispositif selon l'une des revendications 1 à 8, caractérisé par le fait que lesdits moyens indicateurs de l'isolement entre les éléments de contact collectif ($P_1$, $P_2$) des moyens explorateurs est un mégohmmètre ($M\Omega$).

10. Dispositif selon l'une des revendications 1 à 9, caractérisé par le fait que les moyens palpeurs spécifiques (S') sont agencés pour être entraînés en translation et en appui glissant sur les moyens explorateurs ($P_1$, $P_2$).

**Patentansprüche**

1. Vorrichtung zur qualitativen Kontrolle der galvanischen Isolierung zwischen leitenden Elementen einer komplexen gedruckten Schaltung, mit Prüfeinrichtungen für metallische Plättchen, die auf einer der Seiten der gedruckten Schaltung zugänglich sind, und mit Anzeigeeinrichtungen für die galvanische Isolierung, dadurch gekennzeichnet, dass sie spezielle Tasteinrichtungen (S') enthält, die mehrere individuelle Kontaktelemente ($A'_1$, $A'_2$, $A'_3$) aufweisen, die auf einem Isolierschirm verteilt sind, um durch Aufeinanderlegen eine bestimmte Kategorie von Plättchen ($A'_1$, $A'_2$, $A'_3$) aus der Gesamtheit der auf der genannten Seite der gedruckten Schaltung (S) zugänglichen metallischen Plättchen auszuwählen, wobei die Prüfeinrichtungen in der Lage sind, die individuellen Kontaktelemente ($A'_1$, $A'_2$, $A'_3$) der speziellen Tasteinrichtungen (S') zu untersuchen, und kollektive Kontaktelemente ($P_1$, $P_2$) enthalten, die gegeneinander isoliert und zwischen ihnen befestigt sind, um die dynamisch die Anzeige eines eventuellen Isolierungsdefektes bewirken zu können, der die verschiedenen leitenden «Verdrahtungsmuster» der gedruckten Schaltung (S) wechselseitig beeinflussen könnte, und dass die Anzeigeeinrichtungen ($M\Omega$) das Ausmass der galvanischen Isolierung zwischen den kollektiven Kontaktelementen ($P_1$, $P_2$) der Prüfeinrichtungen ausdrücken.

2. Vorrichtung nach Anspruch 1, dadurch gekennzeichnet, dass die individuellen Kontaktelemente der speziellen Tasteinrichtungen zweiseitige Kontaktknöpfe ($A'_1$, $A'_2$, $A'_3$) sind, die durch gleichzeitige Metallisierung mehrerer in dem Isolierschirm (S') angebrachten Löcher gebildet sind.

3. Vorrichtung nach einem der Ansprüche 1 und 2, dadurch gekennzeichnet, dass der Isolierschirm (S') eine Folie aus dehnbarem Kunststoff ist.

4. Vorrichtung nach einem der Ansprüche 1 bis 3, dadurch gekennzeichnet, dass die Lage und die Anzahl der individuellen Kontaktelemente der speziellen Tasteinrichtungen (S') derart auf dem Isolierschirm (S') verteilt sind, dass ein einziger Kontaktknopf pro «Verdrahtungsmuster» der gedruckten Schaltung (S) zur Verfügung steht.

5. Vorrichtung nach einem der Ansprüche 1 bis 4, dadurch gekennzeichnet, dass die kollektiven Kontaktelemente der Prüfeinrichtung aneinander angrenzende leitende Zonen ($P_1$, $P_2$) sind, die durch Oberflächenmetallisierung einer verformbaren, isolierenden Unterlage gebildet sind.

6. Vorrichtung nach Anspruch 5, dadurch gekennzeichnet, dass die verformbare isolierende Unterlage der Prüfeinrichtungen eine Folie aus dehnbarem Kunststoff ist, die auf die Oberfläche eines kompressibelen Stützkörpers aufgetragen ist.

7. Vorrichtung nach einem der Ansprüche 5 und 6, dadurch gekennzeichnet, dass die aneinander angrenzenden leitenden Zonen ($P_1$, $P_2$) der Prüfeinrichtungen koplanar angeordnet und gegeneinander durch einen Zwischenraum konstanter Breite isoliert sind, die geringfügig grösser ist als der Durchmesser der individuellen Kontaktelemente ($A'_1$, $A'_2$, $A'_3$) die auf der Aussenfläche des Isolierschirmes (S') der speziellen Tasteinrichtungen erscheinen, wenn er fest auf die Prüfseite der gedruckten Schaltung (S) aufgelegt ist.

8. Vorrichtung nach einem der Ansprüche 6 und 7, dadurch gekennzeichnet, dass das Material der dehnbaren Folie der Prüfeinrichtungen Polyimid und dasjenige des kompressiblen Körpers Polyurethan ist.

9. Vorrichtung nach einem der Ansprüche 1 bis 8, dadurch gekennzeichnet, dass die Anzeigeeinrichtungen für die Isolierung zwischen den Kollektiven Kontaktelementen ($P_1$, $P_2$) der Prüfeinrichtungen ein Megohmmeter (MΩ) ist.

10. Vorrichtung nach einem der Ansprüche 1 bis 9, dadurch gekennzeichnet, dass die speziellen Tasteinrichtungen (S') translatorisch und in gleitendem Kontakt über die Prüfeinrichtungen ($P_1$, $P_2$) ziehbar sind.

**Claims**

1. Device for the quality control of the galvanic insulation between conducting elements of a complex printed circuit, comprising means for scanning metallic studs accessible on one of the faces of the printed circuit, and means for indicating the galvanic insulation, characterized in that it comprises specific sensor means (S') comprising a plurality of individual contact elements ($A'_1$, $A'_2$, $A'_3$) localized on an insulating screen for effecting, by superposition, the selection of a category of studs ($A_1$, $A_2$, $A_3$) predefined from all the metallic studs accessible on said face of the printed circuit (S), said scanning means being arranged, for scanning the individual contact elements ($A'_1$, $A'_2$, $A'_3$) of the specific sensor means (S') and comprising mutually insulated and mutually fixed collective contact elements ($P_1$, $P_2$) to allow dynamic detection of a possible defect in insulating affecting mutually the different conducting «trees» of the printed circuit (S); and the indicator means (MΩ) giving the measurement of the galvanic insulation existing between the collective contact elements ($P_1$, $P_2$) of the scanning means.

2. Device of Claim 1, characterized in that the individual contact elements of the specific sensor means are double-face conducting studs ($A'_1$, $A'_2$, $A'_3$) obtained by simultaneous metallization of a plurality of holes made in the insulating screen (S').

3. Device of one of Claims 1 and 2, characterized in that the insulating screen (S') is a film of supple plastics material.

4. Device of one of Claims 1 to 3, characterized in that the localization and the number of the individual contact elements of the specific sensor means are distributed over the insulating screen (S') so as to have one conducting stud only per «tree» of the printed circuit (S).

5. Device of one of Claims 1 to 4, characterized in that the collective contact elements of the scanning means are contiguous conducting zones ($P_1$, $P_2$) obtained by superficial metallization of a deformable insulating support.

6. Device of Claim 5, characterized in that the deformable insulating support of the scanning means is a film of supple plastics material applied on the face of a compressible support body.

7. Device of one of Claims 5 and 6, characterized in that the contiguous conducting zones ($P_1$, $P_2$) or the scanning means are complanar and mutually insulated by a space of constant width slightly greater than the diameter of the individual conducting studs ($A'_1$, $A'_2$, $A'_3$) appaearing on the outer face of the insulating screen (S') of the specific sensor means when it is integrally superposed on the test face of the printed circuit (S).

8. Device of one of Claims 6 and 7, characterized in that the material of the supple film of the scanning means is polyimide and that of the compressible body is polyurethane.

9. Device of one of Claims 1 to 8, characterized in that said means for indicating the insulation between the collective contact elements ($P_1$, $P_2$) of the scanning means is a megohmmeter (MΩ).

10. Device of one of Claims 1 to 9, characterized in that the specific sensor means (S') are arranged for being translatory moved and in sliding abutment on the scanning means ($P_1$, $P_2$).

Fig.1.

Fig.2

Fig.3